# EUROPEAN PATENT SPECIFICATION

(11) **EP 4 501 672 B1**
(45) Date of publication and mention of the grant of the patent: **25.03.2026**
(21) Application number: 24182593.4
(22) Date of filing: 17.06.2024
(51) Int. Cl.: B60H 1/00

(54) **THERMAL MANAGEMENT ASSEMBLY WITH FLEXIBLE CONNECTING COMPONENT**
WÄRMEVERWALTUNGSANORDNUNG MIT FLEXIBLER VERBINDUNGSKOMPONENTE
ENSEMBLE DE GESTION THERMIQUE AVEC COMPOSANT DE CONNEXION FLEXIBLE

(30) Priority: 01.08.2023 CN 202310960704
(43) Date of publication of application: 05.02.2025
(73) Proprietor: Zhejiang Sanhua Intelligent Controls Co., Ltd., Shaoxing City, Zhejiang 312500 (CN)
(72) Inventor: TAN, Yongxiang, Shaoxing City, Zhejiang, 312500 (CN); XU, Yungen, Shaoxing City, Zhejiang, 312500 (CN); GUO, Yao, Shaoxing City, Zhejiang, 312500 (CN); LIU, Yongqi, Shaoxing City, Zhejiang, 312500 (CN)
(74) Representative: Michalski Hüttermann & Partner Patentanwälte mbB

(56) References cited:
- CN-A- 115 123 111
- CN-U- 211 233 423
- US-B2- 6 909 607

## Description

### CROSS-REFERENCE TO RELATED APPLICATION

This patent application claims priority of a Chinese Patent Application No. 202310960704.2, filed on August 1, 2023 and titled "THERMAL MANAGEMENT ASSEMBLY"

### TECHNICAL FIELD

The present invention relates to the field of thermal management technology, and in particular, to a thermal management assembly.

### BACKGROUND

In a thermal management assembly, a sensor and a flow channel component are fixed and detect the temperature, pressure and other parameters of the fluid in the flow channel. A control component is located in a box body and electrically connected to the sensor. However, the temperature of thermal management assembly changes greatly when operating. The materials of the flow channel component and the box body are usually different. The difference between the expansion degree of the flow channel component and the expansion degree of the box body causes relative displacement between the flow channel component and the box body, which can easily cause the electrical connection between the sensor and control component to fail due to disconnection.

US 6,909,607 B2 discloses a thermal support that may receive one or more power electronic circuits. The support may aid in removing heat from the circuits through fluid circulating through the support. Power electronic circuits are thermally matched, such as between component layers and between the circuits and the support. The support may form a shield from both external EMI/RFI and from interference generated by operation of the power electronic circuits. Features may be provided to permit and enhance connection of the circuitry to external circuitry, such as improved terminal configurations. Modular units may be assembled that may be coupled to electronic circuitry via plug-in arrangements or through interface with a backplane or similar mounting and interconnecting structures.

### SUMMARY

An object of the present invention is to provide a thermal management assembly with reliable connection.

An embodiment of the present invention as defined in claim 1 provides a thermal management assembly, including:
a flow channel component, the flow channel component having a first expansion coefficient;
a box body, the box body having a second expansion coefficient, the second expansion coefficient being different from the first expansion coefficient;
a sensor, the sensor and the flow channel component being fixedly connected;
a control component, the control component and the box body being fixedly connected; and
a flexible connecting component, one end of the flexible connecting component being electrically connected to the sensor, and another end of the flexible connecting component being electrically connected to the control component.

In the embodiment of the present invention, one end of the flexible connecting component is electrically connected to the sensor, and another end of the flexible connecting component is electrically connected to the control component, the flexible connecting component is deformable, which reduces the relative displacement between the flow channel component and the box body due to different degrees of expansion when the thermal management assembly is operating. The flexible connecting component of the embodiment of the present invention is capable of reducing the stress at the connection between the flexible connecting component and the sensor, and the connection between the flexible connecting component and the control component, thereby making the connection between the flexible connecting component and the sensor, and the connection between the flexible connecting component and the control component reliable.

### BRIEF DESCRIPTION OF DRAWINGS

FIG. 1 is a schematic perspective structural view of a thermal management assembly in accordance with an embodiment of the present invention;
FIG. 2 is an exploded view of the thermal management assembly in accordance with the embodiment of the present invention;
FIG. 3 is an exploded schematic view of a box body and a sensor assembly in accordance with the embodiment of the present invention;
FIG. 4 is a schematic cross-sectional view of a sensor, a flexible connecting component, and a control component assembly in accordance with the embodiment of the present invention;
FIG. 5 is an assembly schematic view of the sensor, the flexible connecting component, and the control component assembly in accordance with the embodiment of the present invention;
FIG. 6 is an exploded cross-sectional view of the sensor, a first fixing mechanism, and the flexible connecting component in accordance with the embodiment of the present invention;
FIG. 7 is an exploded schematic view of the first fixing mechanism, an elastic component, a box body, etc., in accordance with the embodiment of the present invention;
FIG. 8 is a schematic cross-sectional view of the first fixing mechanism, the elastic component, and the box body in accordance with the embodiment of the present invention; and
FIG. 9 is an exploded schematic view of the control component, a second fixing mechanism, the flexible connecting component, etc., in accordance with the embodiment of the present invention.

### DETAILED DESCRIPTION

Exemplary embodiments will be described in detail here, examples of which are shown in drawings. When referring to the drawings below, unless otherwise indicated, same numerals in different drawings represent the same or similar elements. The examples described in the following exemplary embodiments do not represent all embodiments consistent with this application. Rather, they are merely examples of devices and methods consistent with the invention as defined in the appended claims.

The terminology used in this application is only for the purpose of describing particular embodiments, and is not intended to limit this application. The singular forms "a", "said", and "the" used in this application and the appended claims are also intended to include plural forms unless the context clearly indicates other meanings.

It should be understood that the terms "first", "second" and similar words used in the specification and claims of this application do not represent any order, quantity or importance, but are only used to distinguish different components. Similarly, "an" or "a" and other similar words do not mean a quantity limit, but mean that there is at least one; "multiple" or "a plurality of" means two or more than two. Unless otherwise noted, "front", "rear", "lower" and/or "upper" and similar words are for ease of description only and are not limited to one location or one spatial orientation. Similar words such as "include" or "comprise" mean that elements or objects appear before "include" or "comprise" cover elements or objects listed after "include" or "comprise" and their equivalents, and do not exclude other elements or objects. The term "a plurality of" mentioned in the present invention includes two or more.

Hereinafter, some embodiments of the present invention will be described in detail with reference to the accompanying drawings.

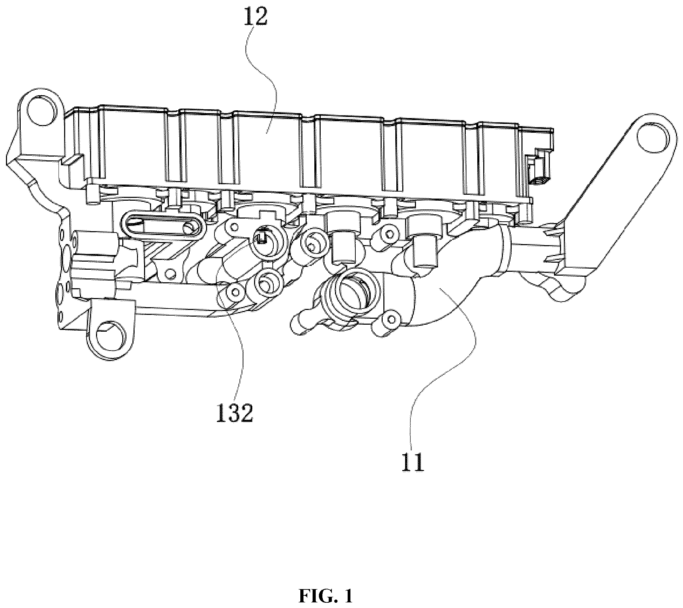

According to a specific embodiment of a thermal management assembly of the present invention, as shown in FIG. 1 to FIG. 3, the thermal management assembly includes a flow channel component 11, a box body 12, a sensor 13, a control component 14 and a flexible connecting component 15. The flow channel component 11 defines a first accommodation space 111 located between a flow channel 112 and the box body 12. The sensor 13 includes a sensor body 131. The box body 12 defines a second accommodation space 121. The sensor body 131 is located in the first accommodation space 111 and/or the second accommodation space 121, and the sensor body 131 and the flow channel component 11 are fixedly connected.

In some possible embodiments, referring to FIG. 1, the sensor 13 further includes a detection portion 132. The detection portion 132 is located in the flow channel 112 to detect parameters such as pressure and/or temperature of the fluid located in the flow channel 112.

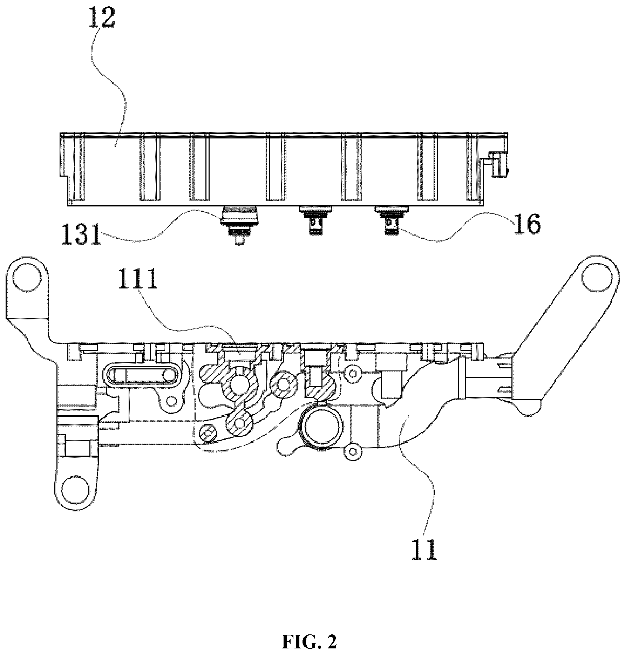

As shown in FIG. 2 to FIG. 5, the control component 14 is located in the second accommodation space 121. The control component 14 and the box body 12 are fixedly connected. One end of the flexible connecting component 15 is electrically connected to the sensor 13, and another end of the flexible connecting component 15 is electrically connected to the control component 14. The temperature changes greatly when the thermal management assembly is operating, and the flow channel component 11 and the box body 12 are made of different materials, so that when the thermal management assembly is operating, the expansion degree of the flow channel component 11 and the expansion degree of the box body 12 are different. The flexible connecting component 15 is deformable to reduce the relative displacement between the flow channel component 11 and the box body 12 due to different expansion degrees when the thermal management assembly is operating, thereby reducing the stress borne by the connection between the flexible connecting component 15 and the sensor 13, and the connection between the flexible connecting component 15 and the control component 14. As a result, the connection between the flexible connecting component 15 and the sensor 13, and the connection between the flexible connecting component 15 and the control component 14 are made stable and reliable.

In this embodiment, the flexible connecting component 15 is a flexible circuit board. The flexible circuit board has a simple structure and is lightweight, and the flexible circuit board is also convenient for connecting the sensor 13 and the control component 14, so that the flexible connecting component 15 can be installed in the box body 12 with a small size. The flexible circuit board is flexible and has a certain degree of rigidity. Therefore, under vibration conditions, the vibration amplitude of the flexible circuit board is small, which is capable of reducing the interference between the flexible connecting component 15 and other components of the thermal management assembly, and can further reduce the stress at the connection between the flexible connecting component 15 and the sensor 13, and the connection between the flexible connecting component 15 and the control component 14. As a result, the connection between the flexible connecting component 15 and the sensor 13, and the connection between the flexible connecting component 15 and the control component 14 are made stable and reliable.

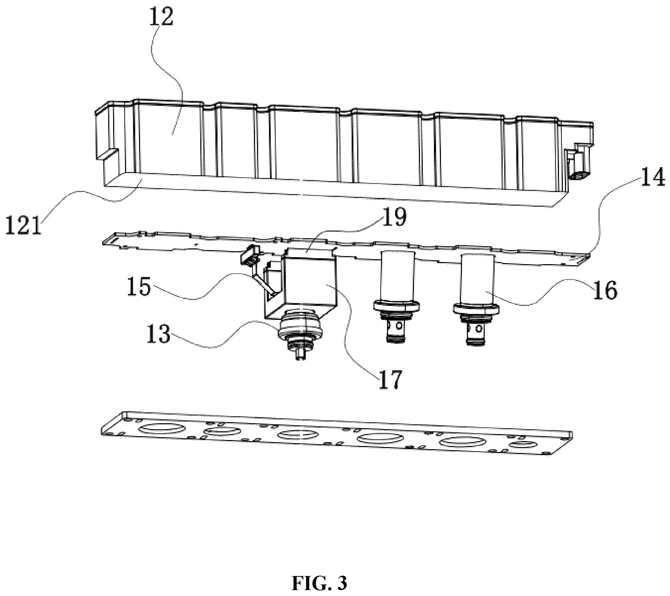

As shown in FIG. 2 and FIG. 3, the thermal management assembly further includes at least two valve cores 16 which are at least partially located in the second accommodation space 121. The at least two valve cores 16 are electrically connected to the control component 14. In this embodiment, the valve cores 16, the control component 14 and the flexible connecting component 15 are integrated to the box body 12, so that the thermal management assembly has a high integration level and is conducive for miniaturization.

As shown in FIG. 3, FIG. 4 and FIG. 6, the thermal management assembly further includes a first fixing mechanism 17 and a first connecting component 18. The first fixing mechanism 17 is at least partially located in the second accommodation space 121. The first fixing mechanism 17 is connected to the box body 12.

In this embodiment, the first fixing mechanism 17 has a substantially U-shaped structure. Two side walls of the U-shaped structure are connected to the box body 12, respectively. The flexible connecting component 15 and the sensor 13 are located on two sides of a bottom wall of the U-shaped structure of the first fixing mechanism 17, respectively. The flexible connecting component 15 is partially located between the two side walls of the U-shaped structure. The first fixing mechanism 17 includes a first wall portion 171 and a second wall portion 172. The first wall portion 171 is located at an end of the first fixing mechanism 17 close to the sensor 13. The second wall portion 172 is located at an end of the first fixing mechanism 17 close to the flexible connecting component 15. The first fixing mechanism 17 has a first wall surface 173 and a second wall surface 174. An end surface of the first wall portion 171 close to the sensor 13 is the first wall surface 173. An end surface of the second wall portion 172 close to the control component 14 is the second wall surface 174. The first fixing mechanism 17 has a first connecting through hole 175 which penetrates from the first wall surface 173 to the second wall surface 174. The first connecting component 18 passes through the first connecting through hole 175. One end of the first connecting component 18 is electrically connected to the sensor 13, and another end of the first connecting component 18 is electrically connected to the flexible connecting component 15. The first connecting through hole 175 plays a positioning role for the assembly of the first connecting component 18 so that two ends of the first connecting component 18 can accurately connect the sensor 13 and the flexible connecting component 15.

In this embodiment, a plurality of first connecting components 18 are provided. The plurality of first connecting components 18 are integrated to the first fixing mechanism 17. For example, the first connecting components 18 and the first fixing mechanism 17 are injection molded together, which reduces the assembly steps between the first connecting component 18, the sensor 13 and the flexible connecting component 15, and improves the convenience of the first connecting component 18 connecting the sensor 13 and the flexible connecting component 15.

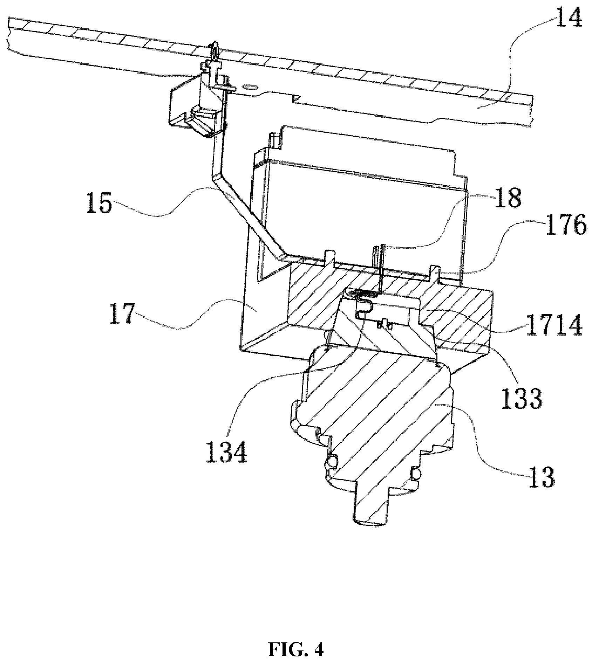

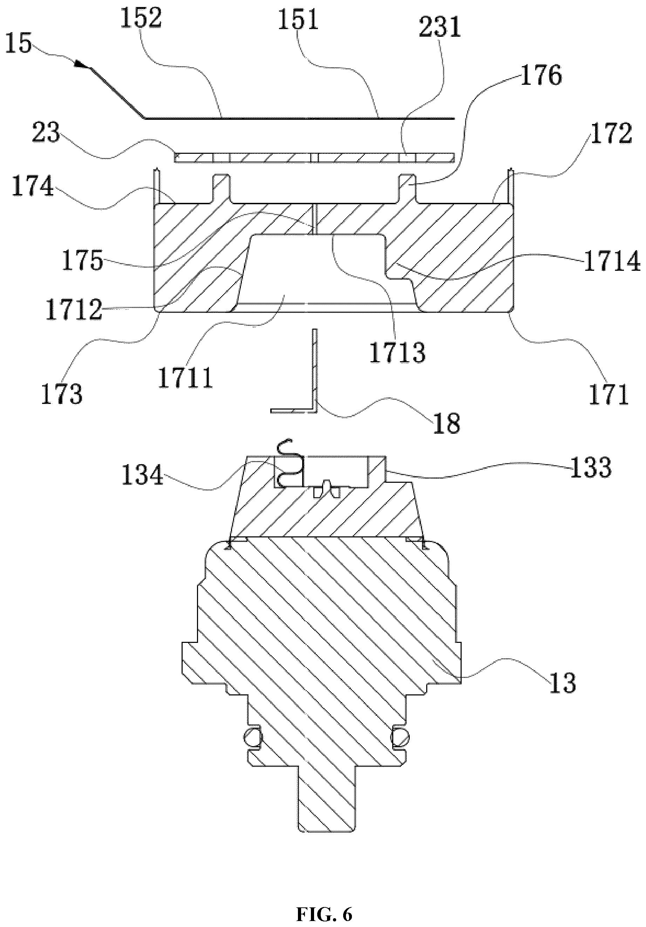

As shown in FIG. 4 and FIG. 6, the first wall portion 171 defines a receiving groove 1711 which is located at a position of the first wall portion 171 close to the sensor 13. The receiving groove 1711 is a structure in which part of the first wall portion 171 is recessed toward a side away from the sensor 13. The first wall portion 171 includes a peripheral wall 1712 and a bottom wall 1713. The peripheral wall 1712 is a groove wall whose peripheral side surrounds the receiving groove 1711. The bottom wall 1713 is a groove wall of an end of the receiving groove 1711 away from an opening of the receiving groove 1711. The sensor 13 is at least partially located in the receiving groove 1711, and one end of the sensor 13 close to the first fixing mechanism 17 is in contact with the peripheral wall 1712.

The first wall portion 171 includes a first positioning structure 1714. The first positioning structure 1714 is located in the receiving groove 1711. The sensor 13 includes a second positioning structure 133. The first positioning structure 1714 and the second positioning structure 133 are concave-convexly matched or snap-fitted.

In some possible embodiments, the first positioning structure 1714 is a structure in which part of the peripheral wall 1712 and/or part of the bottom wall 1713 protrudes toward a side close to the sensor 13. The second positioning structure 133 is a positioning notch, and the second positioning structure 133 is located at a position where the sensor 13 is close to the first positioning structure 1714. The first positioning structure 1714 is located at the second positioning structure 133. This structure plays a positioning role for the assembly of the sensor 13 and the first fixing mechanism 17, thereby facilitating the assembly of the sensor 13 and the first fixing mechanism 17, and making the assembly position of the sensor 13 and the first fixing mechanism 17 accurate. Moreover, this structure can also limit the relative movement between the sensor 13 and the first fixing mechanism 17 to a certain extent, and keep the sensor 13 and the first fixing mechanism 17 in an accurate assembly position, thereby making the connection between the sensor 13 and the first connecting component 18 stable and reliable.

In some other possible embodiments, the first positioning structure 1714 is a structure in which part of the peripheral wall 1712 and/or part of the bottom wall 1713 is recessed toward a side away from the sensor 13. The second positioning structure 133 is a structure in which the end of the sensor 13 close to the first fixing mechanism 17 protrudes toward the side close to the first positioning mechanism. Moreover, the second positioning structure 133 is located at a position where the sensor 13 is close to the first positioning structure 1714. The second positioning structure 133 is located at the first positioning structure 1714, so that the assembly position of the sensor 13 and the first fixing mechanism 17 is accurate, and the connection between the sensor 13 and the first connecting component 18 is stable and reliable.

As shown in FIG. 4 and FIG. 6, along a direction from the opening of the receiving groove 1711 to the bottom wall 1713, the peripheral wall 1712 is inclined toward the side close to the sensor 13. The peripheral wall 1712 of this structure has the function of guiding the movement direction of the sensor 13, which can improve the convenience of assembling the sensor 13 and the first fixing mechanism 17. At the same time, when the thermal management assembly is in operating condition, due to the difference between the expansion degree of the flow channel component 11 and the expansion degree of the box body 12, when relative movement occurs between the sensor 13 and the first fixing mechanism 17, the peripheral wall 1712 of this structure facilitates guiding the sensor 13 to move in a direction of the expansion pressure, thereby reducing the risk of damage to the sensor 13.

As shown in FIG. 4 and FIG. 6, the sensor 13 includes an elastic connecting component 134. The elastic connecting component 134 is located at a position of the sensor 13 close to the first connecting component 18. One end of the elastic connecting component 134 is electrically connected to the detection portion 132, and another end of the elastic connecting component 134 is electrically connected to the first connecting component 18.

In this embodiment, during assembly, the sensor 13 compresses the elastic connecting component 134. That is, the elastic connecting component 134 has a certain elastic pre-tightening force, so that when the thermal management assembly is in the operating state and there is relative displacement between the sensor 13 and the first fixing mechanism 17, the elastic connecting component 134 releases the compression amount, so that the sensor 13 and the first connecting component 18 can maintain a stable connection. Of course, when the thermal management assembly is in operating condition and there is relative displacement between the sensor 13 and the first fixing mechanism 17, the sensor 13 can also continue to compress the elastic connecting component 134 so that the sensor 13 and the first connecting component 18 can maintain a stable connection.

In this embodiment, the elastic connecting component 134 is a spring piece. The elastic connecting component 134 of this structure can be electrically connected by contact with the first connecting component 18, so that the structure of the electrical connection between the elastic connecting component 134 and the first connecting component 18 is simple and easy to assemble.

As shown in FIG. 4 and FIG. 6, the flexible connecting component 15 includes a first end portion 151 which is located at an end of the flexible connecting component 15 close to the second wall portion 172. The first end portion 151 fits the second wall portion 172. This structure provides a certain friction force between the first end portion 151 and the second wall portion 172, which is capable of reducing relative movement between the first end portion 151 and the first fixing mechanism 17, and relative movement between the first end portion 151 and the first fixing mechanism 17 leads to the risk of disconnection and failure of the connection between the first end portion 151 and the first connecting component 18.

The first fixing mechanism 17 includes a first limiting structure 176 which is located at an end of the second wall portion 172 close to the first end portion 151. The flexible connecting component 15 includes a second limiting structure 152 which is located at the first end portion 151 close to the first limiting structure 176. The first limiting structure 176 and the second limiting structure 152 are concave-convexly matched or snap-fitted.

In this embodiment, the first limiting structure 176 is a limiting structure in which part of the second wall portion 172 protrudes toward the direction close to the first end portion 151. The second limiting structure 152 is a limiting hole or a limiting groove. The first limiting structure 176 is located at the second limiting structure 152. This structure can limit the relative movement between the first fixing mechanism 17 and the first end portion 151 to a certain extent, reducing the stress at the connection between the flexible connecting component 15 and the first connecting component 18, thereby reducing the risk of disconnection and failure of the electrical connection between the flexible connecting component 15 and the first connecting component 18, further making the connection between the flexible connecting component 15 and the first connecting component 18 stable and reliable.

In this embodiment, the first limiting structure 176 is a cylindrical structure. The second limiting structure 152 is a circular hole structure. The number of the first limiting structures 176 is two, and the number of the second limiting structures 152 is at least two. The cylindrical structure and circular hole structure are easy to process and have low cost. The number of the first limiting structure 176 and the second limiting structure 152 is at least two, so that the first limiting structure 176 and the second limiting structure 152 can limit the relative movement between the first fixing mechanism 17 and the flexible connecting component 15 to a certain extent, while the relative rotation between the first fixing mechanism 17 and the flexible connecting component 15 can also be restricted.

In this embodiment, as shown in FIG. 6, the thermal management assembly further includes a first buffer mechanism 23. The first buffer mechanism 23 is located between the first end portion 151 and the second wall portion 172. Along a thickness direction of the first buffer mechanism 23, the first buffer mechanism 23 defines a first through hole 231 extending through the first buffer mechanism 23. The first through hole 231 is located at a position of the first buffer mechanism 23 close to the first connecting component 18 and the first limiting structure 176. The first connecting component 18 and the first limiting structure 176 both pass through the first through hole 231. When the thermal management assembly is in operating condition, the first buffer mechanism 23 can share the expansion tension force borne by the first end portion 151, thereby improving the safety of the flexible connecting component 15.

In some other possible embodiments, the first limiting structure 176 is a limiting hole or a limiting groove. The second limiting structure 152 is a limiting structure in which part of the first end portion 151 protrudes toward the direction close to the second wall portion 172. The second limiting structure 152 is located at the first limiting structure 176 to limit the relative movement between the first fixing mechanism 17 and the first end portion 151 to a certain extent.

In some other possible embodiments, one of the first limiting structure 176 and the second limiting structure 152 is a triangular, rectangular or other polygonal cube or cone structure, and a remaining one is a hole structure or groove structure adapted to the triangular, rectangular or other polygonal cube or cone structure, so that the first limiting structure 176 and the second limiting structure 152 can limit the relative movement between the first fixing mechanism 17 and the flexible connecting component 15 to a certain extent, while the relative rotation between the second fixing mechanism 21 and the flexible connecting component 15 can also be restricted. The number of the first limiting structure 176 and the number of the second limiting structure 152 may be one or more than three, as long as the limiting can be achieved, which is not limited by the present invention.

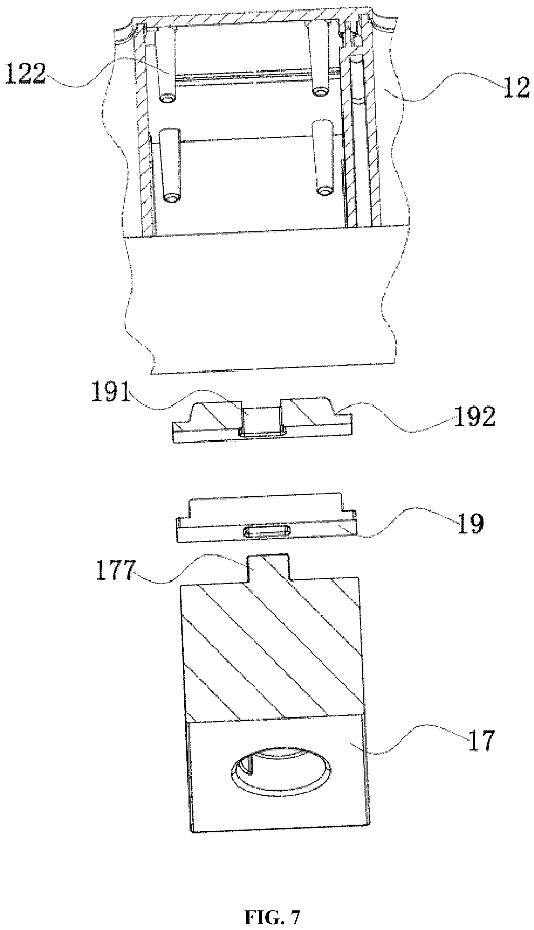

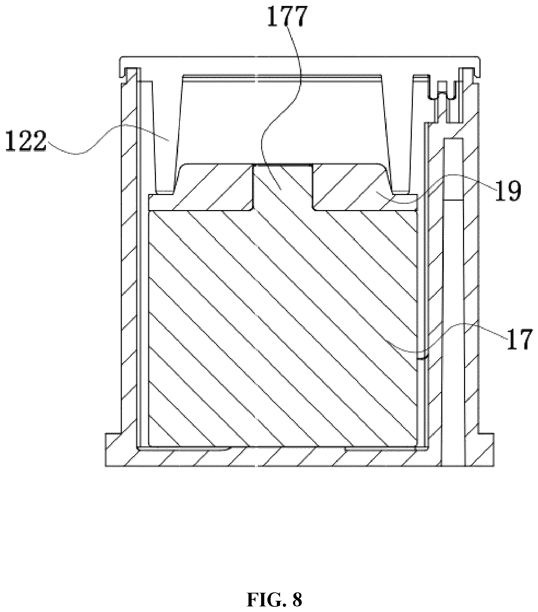

As shown in FIG. 3, FIG. 7 and FIG. 8, the thermal management assembly further includes an elastic component 19. One side of the elastic component 19 in a thickness direction thereof is connected to the first fixing mechanism 17, and another side of the elastic component 19 in the thickness direction thereof is connected to the box body 12.

Specifically, the first fixing mechanism 17 includes a protruding structure 177. The elastic component 19 has a concave hole 191 in which the protruding structure 177 is located. The elastic component 19 has clamping notches 192 which are located at opposite ends of the elastic component 19. The box body 12 includes a clamping structure 122 located in the clamping notches 192, and the clamping structure 122 is in contact with the elastic component 19. When the thermal management assembly is in operating condition, the difference between the expansion degree of the box body 12 and the expansion degree of the flow channel component 11 results in relative displacement between the first fixing mechanism 17 and the box body 12. The first fixing mechanism 17 and the box body 12 are capable of compressing or releasing the elastic component 19. The deformation generated by the elastic component 19 is capable of reducing the relative displacement between the first fixing mechanism 17 and the box body 12 to a certain extent, so that the assembly position of the first fixing mechanism 17, the sensor 13 and the flexible connecting component 15 is accurate.

It is understandable that the concave hole 191 of the elastic component 19 can be replaced by a groove. At the same time, the clamping notches 192 of the elastic component 19 can be replaced by clamping holes or clamping grooves.

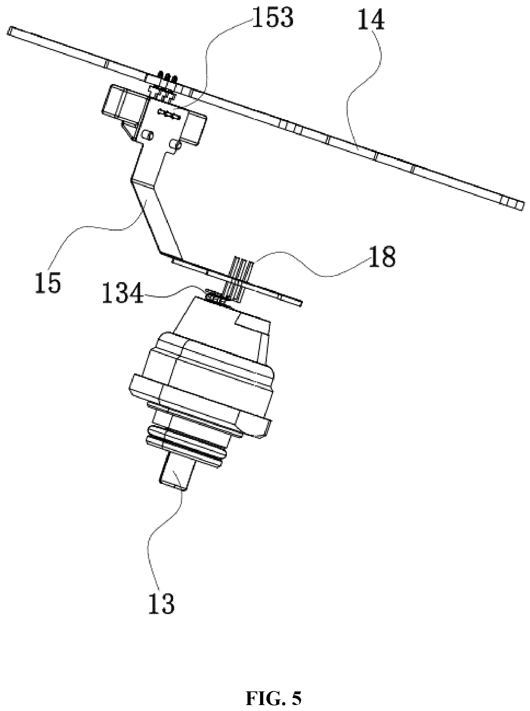

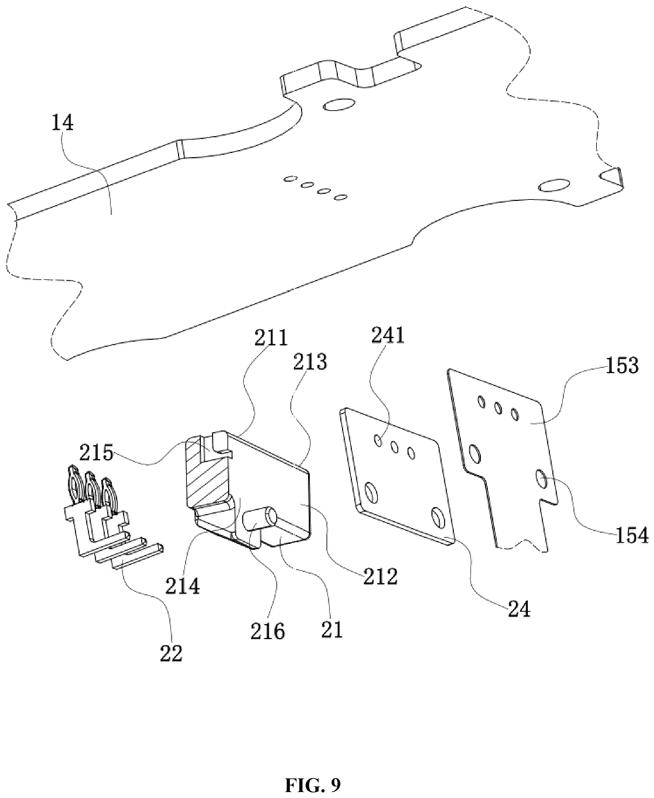

As shown in FIG. 5 and FIG. 9, the flexible connecting component 15 includes a second end portion 153. The second end portion 153 is located at an end of the flexible connecting component 15 close to the control component 14. The thermal management assembly further includes a second fixing mechanism 21 and a second connecting component 22. The control component 14 and the flexible connecting component 15 are located on two sides of the second fixing mechanism 21, respectively. The second fixing mechanism 21 includes a third wall portion 211 and a fourth wall portion 212. The third wall portion 211 is located at an end of the second fixing mechanism 21 close to the control component 14. The fourth wall portion 212 is located at an end of the second fixing mechanism 21 close to the second end portion 153. The second fixing mechanism 21 has a third wall surface 213 and a fourth wall surface 214. An end surface of the third wall portion 211 close to the control component 14 is the third wall surface 213. An end surface of the fourth wall portion 212 close to the second end portion 153 is the fourth wall surface 214.

The second fixing mechanism 21 defines a second connecting through hole 215. The second connecting through hole 215 penetrates the third wall surface 213 to the fourth wall surface 214. The second connecting component 22 passes through the second connecting through hole 215. One end of the second connecting component 22 is electrically connected to the control component 14, and another end of the second connecting component 22 is electrically connected to the second end portion 153. The second connecting through hole 215 plays a positioning role for the assembly of the second connecting component 22 so that two ends of the second connecting component 22 can be accurately connected to the control component 14 and the flexible connecting component 15. In this embodiment, a plurality of second connecting components 22 are provided. Integrating the plurality of second connecting components 22 to the second fixing mechanism 21 reduces the assembly steps among the second connecting components 22, the sensor 13 and the flexible connecting component 15, and improves the convenience of connecting the second connecting components 22 to the sensor 13 and to the flexible connecting component 15.

The second fixing mechanism 21 includes a third limiting structure 216 which is located at an end of the fourth wall portion 212 close to the second end portion 153. The flexible connecting component 15 includes a fourth limiting structure 154 which is located at the second end portion 153 close to the third limiting structure 216. The third limiting structure 216 and the fourth limiting structure 154 are connected or snap-fitted.

In this embodiment, the third limiting structure 216 is a limiting structure in which part of the second wall portion 172 protrudes toward the direction close to the second end portion 153. The fourth limiting structure 154 is a limiting hole or a limiting groove. The third limiting structure 216 is located in the fourth limiting structure 154 to limit the relative movement between the second fixing mechanism 21 and the second end portion 153. This structure reduces the risk of disconnection and failure of the electrical connection between the flexible connecting component 15 and the second connecting component 22, further making the connection between the flexible connecting component 15 and the second connecting component 22 stable and reliable.

In this embodiment, the third limiting structure 216 is a cylindrical structure. The fourth limiting structure 154 is a circular hole. The number of the third limiting structures 216 is two. The number of fourth limiting structures 154 is two. The cylindrical structure and circular hole structure are easy to process and have low cost. The number of the third limiting structure 216 and the number of the fourth limiting structure 154 each are two, so that the third limiting structure 216 and the fourth limiting structure 154 can limit the relative movement between the second fixing mechanism 21 and the flexible connecting component 15 to a certain extent, while the relative rotation between the second fixing mechanism 21 and the flexible connecting component 15 can also be restricted.

In this embodiment, as shown in FIG. 9, the thermal management assembly further includes a second buffer mechanism 24. The second buffer mechanism 24 is located between the second end portion 153 and the fourth wall portion 212. Along a thickness direction of the second buffer mechanism 24, the second buffer mechanism 24 defines a second through hole 241 extending through the second buffer mechanism 24 itself. The second through hole 241 is located at a position of the second buffer mechanism 24 close to the second connecting component 22 and the third limiting structure 216. The second connecting component 22 and the third limiting structure 216 both pass through the second through hole 241. When the thermal management assembly is in the operating state, the second buffer mechanism 24 can share the expansion tension borne by the second end portion 153, thereby improving the safety of the flexible connecting component 15.

In some other possible embodiments, the third limiting structure 216 is a limiting hole or a limiting groove. The fourth limiting structure 154 is a limiting structure in which part of the second end portion 153 protrudes toward the direction close to the second wall portion 172. The fourth limiting structure 154 is located at the third limiting structure 216 to limit the relative movement between the second fixing mechanism 21 and the second end portion 153.

In some other possible embodiments, one of the third limiting structure 216 and the fourth limiting structure 154 is a triangular, rectangular or other polygonal cube or cone structure, and a remaining one is a hole structure or groove structure adapted to the triangular, rectangular or other polygonal cube or cone structure, so that the third limiting structure 216 and the fourth limiting structure 154 can limit the relative movement between the second fixing mechanism 21 and the flexible connecting component 15 to a certain extent, while the relative rotation of the second fixing mechanism 21 and the flexible connecting component 15 can also be restricted.

In the present invention, one end of the flexible connecting component 15 is electrically connected to the sensor 13, and another end of the flexible connecting component 15 is electrically connected to the control component 14. The flexible connecting component 15 is capable of reducing the relative displacement between the flow channel component 11 and the box body 12 due to different degrees of expansion when the thermal management assembly is operating, thereby reducing the stress borne by the connection between the flexible connecting component 15 and the sensor 13, and the connection between the flexible connecting component 15 and the control component 14. As a result, the connection between the flexible connecting component 15 and the sensor 13, and the connection between the flexible connecting component 15 and the control component 14 are made reliable. At the same time, the flexible connecting component 15 is a flexible circuit board. The flexible connecting component 15 can be installed on the box body 12 with a smaller size. Moreover, under vibration conditions, the vibration amplitude of the flexible connecting component 15 is small, further making the connection between the flexible connecting component 15 and the sensor 13, and the connection between the flexible connecting component 15 and the control component 14 stable and reliable.

The above embodiments are only used to illustrate the present invention and not to limit the technical solutions described in the present invention. The understanding of this specification should be based on those skilled in the art. Descriptions of directions, although they have been described in detail in the above-mentioned embodiments of the present invention, those skilled in the art should understand that modifications can still be made to the invention as defined in the appended claims.

## Claims

1. A thermal management assembly, comprising:
a flow channel component (11), the flow channel component (11) having a first expansion coefficient;
a box body (12), the box body (12) having a second expansion coefficient, the second expansion coefficient being different from the first expansion coefficient;
a sensor (13), the sensor (13) and the flow channel component (11) being fixedly connected;
a control component (14), the control component (14) and the box body (12) being fixedly connected; and
a flexible connecting component (15), one end of the flexible connecting component (15) being electrically connected to the sensor (13), and another end of the flexible connecting component (15) being electrically connected to the control component (14);
**characterized in that**:
the thermal management assembly further comprises a first fixing mechanism (17) and a first connecting component (18), the first fixing mechanism (17) is connected to the box body (12), the flexible connecting component (15) and the sensor (13) are located on two sides of the first fixing mechanism (17), respectively;
wherein the first fixing mechanism (17) defines a first connecting through hole (175), the first connecting component (18) passes through the first connecting through hole (175), one end of the first connecting component (18) is electrically connected to the sensor (13), and another end of the first connecting component (18) is electrically connected to the flexible connecting component (15).

2. The thermal management assembly according to claim 1, wherein the flexible connecting component (15) is a flexible circuit board.

3. The thermal management assembly according to claim 1, wherein the first fixing mechanism (17) defines a receiving groove (1711), the first fixing mechanism (17) comprises a peripheral wall (1712) and a bottom wall (1713), the peripheral wall (1712) is a groove wall whose peripheral side surrounds the receiving groove (1711), the bottom wall (1713) is a groove wall at an end of the receiving groove (1711) away from an opening of the receiving groove (1711);
the sensor (13) is at least partially located in the receiving groove (1711), and the sensor (13) fits the peripheral wall (1712);
the first fixing mechanism (17) comprises a first positioning structure (1714), the sensor (13) comprises a second positioning structure (133), the first positioning structure (1714) and the second positioning structure (133) are concave-convexly matched or snap-fitted.

4. The thermal management assembly according to claim 3, wherein along a direction from the opening of the receiving groove (1711) to the bottom wall (1713), the peripheral wall (1712) is inclined toward a side close to the sensor (13).

5. The thermal management assembly according to claim 3, wherein the sensor (13) comprises a detection portion (132) and an elastic connecting component (134); one end of the elastic connecting component (134) is electrically connected to the detection portion (132), and another end of the elastic connecting component (134) is electrically connected to the first connecting component (18).

6. The thermal management assembly according to claim 1, wherein the first fixing mechanism (17) comprises a first limiting structure (176), the first limiting structure (176) is located at one end of the first fixing mechanism (17) close to the flexible connecting component (15);
the flexible connecting component (15) comprises a second limiting structure (152), the second limiting structure (152) is located at a position of the flexible connecting component (15) close to the first limiting structure (176);
the first limiting structure (176) and the second limiting structure (152) are concave-convexly matched or snap-fitted.

7. The thermal management assembly according to claim 1, further comprising an elastic component (19), one side of the elastic component (19) along a thickness direction thereof being connected to the first fixing mechanism (17), and another side of the elastic component (19) along the thickness direction thereof being connected to the box body (12).

8. The thermal management assembly according to claim 1 or 2, further comprising a second fixing mechanism (21) and a second connecting component (22); wherein the control component (14) and the flexible connecting component (15) are located on two sides of the second fixing mechanism (21), respectively;
the second fixing mechanism (21) defines a second connecting through hole (215), the second connecting component (22) is located in the second connecting through hole (215), one end of the second connecting component (22) is electrically connected to the control component (14), and another end of the second connecting component (22) is electrically connected to the flexible connecting component (15);
the second fixing mechanism (21) comprises a third limiting structure (216), the third limiting structure (216) is located at one end of the second fixing mechanism (21) close to the flexible connecting component (15);
the flexible connecting component (15) comprises a fourth limiting structure (154), the fourth limiting structure (154) is located at a position of the flexible connecting component (15) close to the third limiting structure (216);
the third limiting structure (216) and the fourth limiting structure (154) are concave-convexly matched or snap-fitted.

9. The thermal management assembly according to claim 1 or 2, further comprising at least two valve cores (16) which are in contact with the control component (14).

## Patentansprüche

1. Wärmeverwaltungsanordnung, umfassend:
eine Strömungskanalkomponente (11), wobei die Strömungskanalkomponente (11) einen ersten Ausdehnungskoeffizienten aufweist;
einen Kastenkörper (12), wobei der Kastenkörper (12) einen zweiten Ausdehnungskoeffizienten aufweist, der sich vom ersten Ausdehnungskoeffizienten unterscheidet; einen Sensor (13), wobei der Sensor (13) und die Strömungskanalkomponente (11) fest miteinander verbunden sind;
eine Steuerkomponente (14), wobei die Steuerkomponente (14) und der Kastenkörper (12) fest miteinander verbunden sind; und
eine flexible Verbindungskomponente (15), wobei ein Ende der flexiblen Verbindungskomponente (15) elektrisch mit dem Sensor (13) verbunden ist und ein anderes Ende der flexiblen Verbindungskomponente (15) elektrisch mit der Steuerkomponente (14) verbunden ist;
**dadurch gekennzeichnet, dass**:
die Wärmeverwaltungsanordnung ferner einen ersten Befestigungsmechanismus (17) und eine erste Verbindungskomponente (18) umfasst, wobei der erste Befestigungsmechanismus (17) mit dem Kastenkörper (12) verbunden ist, wobei sich die flexible Verbindungskomponente (15) und der Sensor (13) jeweils auf einer von zwei Seiten des ersten Befestigungsmechanismus (17) befinden;
wobei der erste Befestigungsmechanismus (17) ein erstes Verbindungsdurchgangsloch (175) definiert, die erste Verbindungskomponente (18) durch das erste Verbindungsdurchgangsloch (175) hindurchgeht, ein Ende der ersten Verbindungskomponente (18) elektrisch mit dem Sensor (13) verbunden ist und ein anderes Ende der ersten Verbindungskomponente (18) elektrisch mit der flexiblen Verbindungskomponente (15) verbunden ist.

2. Wärmeverwaltungsanordnung nach Anspruch 1, wobei die flexible Verbindungskomponente (15) eine flexible Leiterplatte ist.

3. Wärmeverwaltungsanordnung nach Anspruch 1, wobei der erste Befestigungsmechanismus (17) eine Aufnahmenut (1711) definiert, der erste Befestigungsmechanismus (17) eine Umfangswand (1712) und eine Bodenwand (1713) umfasst, die Umfangswand (1712) eine Nutwand ist, deren Umfangsseite die Aufnahmenut (1711) umgibt, die Bodenwand (1713) eine Nutwand an einem Ende der Aufnahmenut (1711) ist, das von einer Öffnung der Aufnahmenut (1711) entfernt ist;
der Sensor (13) wenigstens teilweise in der Aufnahmenut (1711) angeordnet ist und der Sensor (13) an die Umfangswand (1712) passt;
der erste Befestigungsmechanismus (17) eine erste Positionierungsstruktur (1714) umfasst, der Sensor (13) eine zweite Positionierungsstruktur (133) umfasst, die erste Positionierungsstruktur (1714) und die zweite Positionierungsstruktur (133) konkav-konvex aufeinander abgestimmt oder schnappverbunden sind.

4. Wärmeverwaltungsanordnung nach Anspruch 3, wobei entlang einer Richtung von der Öffnung der Aufnahmenut (1711) zur Bodenwand (1713) die Umfangswand (1712) zu einer Seite hin geneigt ist, die nahe am Sensor (13) liegt.

5. Wärmeverwaltungsanordnung nach Anspruch 3, wobei der Sensor (13) einen Erfassungsabschnitt (132) und eine elastische Verbindungskomponente (134) umfasst; wobei ein Ende der elastischen Verbindungskomponente (134) elektrisch mit dem Erfassungsabschnitt (132) verbunden ist und ein anderes Ende der elastischen Verbindungskomponente (134) elektrisch mit der ersten Verbindungskomponente (18) verbunden ist.

6. Wärmeverwaltungsanordnung nach Anspruch 1, wobei der erste Befestigungsmechanismus (17) eine erste Begrenzungsstruktur (176) umfasst, wobei sich die erste Begrenzungsstruktur (176) an einem Ende des ersten Befestigungsmechanismus (17) in der Nähe der flexiblen Verbindungskomponente (15) befindet;
die flexible Verbindungskomponente (15) eine zweite Begrenzungsstruktur (152) umfasst, wobei sich die zweite Begrenzungsstruktur (152) an einer Position der flexiblen Verbindungskomponente (15) in der Nähe der ersten Begrenzungsstruktur (176) befindet;
die erste Begrenzungsstruktur (176) und die zweite Begrenzungsstruktur (152) konkav-konvex aufeinander abgestimmt oder schnappverbunden sind.

7. Wärmeverwaltungsanordnung nach Anspruch 1, ferner umfassend eine elastische Komponente (19), wobei eine Seite der elastischen Komponente (19) entlang ihrer Dickenrichtung mit dem ersten Befestigungsmechanismus (17) verbunden ist und eine andere Seite der elastischen Komponente (19) entlang ihrer Dickenrichtung mit dem Kastenkörper (12) verbunden ist.

8. Wärmeverwaltungsanordnung nach Anspruch 1 oder 2, ferner umfassend einen zweiten Befestigungsmechanismus (21) und eine zweite Verbindungskomponente (22); wobei sich die Steuerkomponente (14) und die flexible Verbindungskomponente (15) jeweils auf einer von zwei Seiten des zweiten Befestigungsmechanismus (21) befinden;
der zweite Befestigungsmechanismus (21) ein zweites Verbindungsdurchgangsloch (215) definiert, die zweite Verbindungskomponente (22) sich in dem zweiten Verbindungsdurchgangsloch (215) befindet, ein Ende der zweiten Verbindungskomponente (22) elektrisch mit der Steuerkomponente (14) verbunden ist und ein anderes Ende der zweiten Verbindungskomponente (22) elektrisch mit der flexiblen Verbindungskomponente (15) verbunden ist;
der zweite Befestigungsmechanismus (21) eine dritte Begrenzungsstruktur (216) umfasst, wobei sich die dritte Begrenzungsstruktur (216) an einem Ende des zweiten Befestigungsmechanismus (21) in der Nähe der flexiblen Verbindungskomponente (15) befindet;
die flexible Verbindungskomponente (15) eine vierte Begrenzungsstruktur (154) umfasst, wobei sich die vierte Begrenzungsstruktur (154) an einer Position der flexiblen Verbindungskomponente (15) in der Nähe der dritten Begrenzungsstruktur (216) befindet;
die dritte Begrenzungsstruktur (216) und die vierte Begrenzungsstruktur (154) konkav-konvex aufeinander abgestimmt oder zusammengesteckt sind.

9. Wärmeverwaltungsanordnung nach Anspruch 1 oder 2, ferner umfassend wenigstens zwei Ventilkerne (16), die mit der Steuerkomponente (14) in Kontakt stehen.

## Revendications

1. Ensemble de gestion thermique, comprenant :
un composant de canal d'écoulement (11), le composant de canal d'écoulement (11) possédant un premier coefficient de dilatation ;
un corps de boîte (12), le corps de boîte (12) possédant un second coefficient de dilatation, le second coefficient de dilatation étant différent du premier coefficient de dilatation ;
un capteur (13), le capteur (13) et le composant de canal d'écoulement (11) étant connectés de manière fixe ;
un composant de commande (14), le composant de commande (14) et le corps de boîtier (12) étant connectés de manière fixe ; et
un composant de connexion flexible (15), une extrémité du composant de connexion flexible (15) étant électriquement connectée au capteur (13), et une autre extrémité du composant de connexion flexible (15) étant électriquement connectée au composant de commande (14) ;
**caractérisé en ce que** :
l'ensemble de gestion thermique comprend en outre un premier mécanisme de fixation (17) et un premier composant de connexion (18), le premier mécanisme de fixation (17) est connecté au corps de boîtier (12), le composant de connexion flexible (15) et le capteur (13) sont situés respectivement sur les deux côtés du premier mécanisme de fixation (17) ;
ledit premier mécanisme de fixation (17) définissant un premier trou traversant de connexion (175), ledit premier composant de connexion (18) passant à travers le premier trou traversant de connexion (175), une extrémité du premier composant de connexion (18) étant électriquement connectée au capteur (13), et une autre extrémité du premier composant de connexion (18) étant électriquement connectée au composant de connexion flexible (15).

2. Ensemble de gestion thermique selon la revendication 1, ledit composant de connexion flexible (15) étant une carte de circuit flexible.

3. Ensemble de gestion thermique selon la revendication 1, ledit premier mécanisme de fixation (17) définissant une rainure de réception (1711), ledit premier mécanisme de fixation (17) comprenant une paroi périphérique (1712) et une paroi de fond (1713), ladite paroi périphérique (1712) étant une paroi de rainure dont le côté périphérique entoure la rainure de réception (1711), ladite paroi de fond (1713) étant une paroi de rainure au niveau d'une extrémité de la rainure de réception (1711) éloignée d'une ouverture de la rainure de réception (1711) ;
ledit capteur (13) étant au moins partiellement situé dans la rainure de réception (1711), et ledit capteur (13) s'adaptant à la paroi périphérique (1712) ;
ledit premier mécanisme de fixation (17) comprenant une première structure de positionnement (1714), ledit capteur (13) comprenant une seconde structure de positionnement (133), ladite première structure de positionnement (1714) et ladite seconde structure de positionnement (133) étant appariées de manière concave-convexe ou encliquetées.

4. Ensemble de gestion thermique selon la revendication 3, le long d'une direction allant de l'ouverture de la rainure de réception (1711) à la paroi de fond (1713), ladite paroi périphérique (1712) étant inclinée vers un côté proche du capteur (13).

5. Ensemble de gestion thermique selon la revendication 3, ledit capteur (13) comprenant une partie de détection (132) et un composant de connexion élastique (134) ; une extrémité du composant de connexion élastique (134) étant électriquement connectée à la partie de détection (132), et une autre extrémité du composant de connexion élastique (134) étant électriquement connectée au premier composant de connexion (18).

6. Ensemble de gestion thermique selon la revendication 1, ledit premier mécanisme de fixation (17) comprenant une première structure de limitation (176), ladite première structure de limitation (176) étant située au niveau d'une extrémité du premier mécanisme de fixation (17) à proximité du composant de connexion flexible (15) ;
ledit composant de connexion flexible (15) comprenant une deuxième structure de limitation (152), ladite deuxième structure de limitation (152) étant située au niveau d'une position du composant de connexion flexible (15) à proximité de la première structure de limitation (176) ;
ladite première structure de limitation (176) et ladite deuxième structure de limitation (152) étant appariées de manière concave-convexe ou encliquetées.

7. Ensemble de gestion thermique selon la revendication 1, comprenant en outre un composant élastique (19), un côté du composant élastique (19) le long d'une direction d'épaisseur de celui-ci étant connecté au premier mécanisme de fixation (17), et un autre côté du composant élastique (19) le long de la direction d'épaisseur de celui-ci étant connecté au corps de boîtier (12).

8. Ensemble de gestion thermique selon la revendication 1 ou 2, comprenant en outre un second mécanisme de fixation (21) et un second composant de connexion (22) ; ledit composant de commande (14) et ledit composant de connexion flexible (15) étant situés respectivement sur les deux côtés du second mécanisme de fixation (21) ;
ledit second mécanisme de fixation (21) définissant un second trou traversant de connexion (215), ledit second composant de connexion (22) étant situé dans le second trou traversant de connexion (215), une extrémité du second composant de connexion (22) étant électriquement connectée au composant de commande (14), et une autre extrémité du second composant de connexion (22) étant électriquement connectée au composant de connexion flexible (15) ;
ledit second mécanisme de fixation (21) comprenant une troisième structure de limitation (216), ladite troisième structure de limitation (216) étant située au niveau d'une extrémité du second mécanisme de fixation (21) à proximité du composant de connexion flexible (15) ;
ledit composant de connexion flexible (15) comprenant une quatrième structure de limitation (154), la quatrième structure de limitation (154) étant située au niveau d'une position du composant de connexion flexible (15) à proximité de la troisième structure de limitation (216) ; ladite troisième structure de limitation (216) et ladite quatrième structure de limitation (154) étant appariées de manière concave-convexe ou encliquetées.

9. Ensemble de gestion thermique selon la revendication 1 ou 2, comprenant en outre au moins deux noyaux (16) de soupape qui sont en contact avec le composant de commande (14).
